# EUROPEAN PATENT SPECIFICATION

(11) **EP 2 365 042 B1**
(45) Date of publication and mention of the grant of the patent: **25.01.2017**
(21) Application number: 11157296.2
(22) Date of filing: 08.03.2011
(51) Int. Cl.: C09G 1/02, C09K 3/14, H01L 21/02

(54) **POLISHING COMPOSITION AND POLISHING METHOD USING THE SAME**
POLIERZUSAMMENSETZUNG UND POLIERVERFAHREN DAFÜR
COMPOSITION DE POLISSAGE ET PROCÉDÉ DE POLISSAGE L'UTILISANT

(30) Priority: 10.03.2010 JP 2010053528; 03.03.2011 JP 2011046673
(43) Date of publication of application: 14.09.2011
(73) Proprietor: FUJIMI INCORPORATED, Nishibiwajima-cho, Kiyosu-shi Aichi 452-8502 (JP)
(72) Inventor: Morinaga, Hitoshi, Kiyosu-shi Aichi 452-8502 (JP); Tamai, Kazusei, Kiyosu-shi Aichi 452-8502 (JP); Asano, Hiroshi, Kiyosu-shi Aichi 452-8502 (JP)
(74) Representative: Neuefeind, Regina

(56) References cited:
- EP-A2- 1 863 074
- WO-A1-03/050859
- WO-A2-2009/046311
- JP-A- 2005 117 027
- JP-A- 2008 068 390
- US-A1- 2002 185 054
- George A Parks: "The Isoelectric Points of Solid Oxides, Solid Hydroxides, and Aqueous Hydroxo Complex Systems", Chemical reviews, 1 April 1965 (1965-04-01), pages 177-198, XP055073944, DOI: 10.1021/cr60234a002 Retrieved from the Internet: URL:http://pubs.acs.org/doi/pdf/10.1021/cr 60234a002 [retrieved on 2013-08-02]
- DELGADO ET AL: "Measurement and interpretation of electrokinetic phenomena", JOURNAL OF COLLOID AND INTERFACE SCIENCE, ACADEMIC PRESS, NEW YORK, NY, US, vol. 309, no. 2, 11 April 2007 (2007-04-11), pages 194-224, XP022020947, ISSN: 0021-9797, DOI: 10.1016/J.JCIS.2006.12.075
- DORIAN HANAOR ET AL: "The effects of carboxylic acids on the aqueous dispersion and electrophoretic deposition of ZrO", JOURNAL OF THE EUROPEAN CERAMIC SOCIETY, ELSEVIER SCIENCE PUBLISHERS, BARKING, ESSEX, GB, vol. 32, no. 1, 7 August 2011 (2011-08-07) , pages 235-244, XP028319602, ISSN: 0955-2219, DOI: 10.1016/J.JEURCERAMSOC.2011.08.015 [retrieved on 2011-08-11]
- GREENWOOD R ET AL: "Selection of Suitable Dispersants for Aqueous Suspensions of Zirconia and Titania Powders using Acoustophoresis", JOURNAL OF THE EUROPEAN CERAMIC SOCIETY, ELSEVIER SCIENCE PUBLISHERS, BARKING, ESSEX, GB, vol. 19, no. 4, 1 April 1999 (1999-04-01), pages 479-488, XP004160628, ISSN: 0955-2219, DOI: 10.1016/S0955-2219(98)00208-8
- SARAVANAN ET AL: "Surface chemical studies on SiC suspension in the presence of chitosan", CERAMICS INTERNATIONAL, ELSEVIER, AMSTERDAM, NL, vol. 32, no. 6, 1 January 2006 (2006-01-01), pages 637-646, XP005457723, ISSN: 0272-8842, DOI: 10.1016/J.CERAMINT.2005.04.023

## Description

### BACKGROUND OF THE INVENTION

The present invention relates to a polishing composition for use in polishing an object to be polished formed of a substrate material for optical devices, a substrate material for power devices, or a compound semiconductor material.

The substrate material for optical devices and the substrate material for power devices refer to sapphire. The compound semiconductor material refers to indium arsenide.

Since substrates or films formed of these materials usually remain stable with respect to chemical action such as oxidation, complexation, and etching, processing the substrates or the films by polishing is not easy. Accordingly, the processing is commonly performed by grinding or cutting using a hard material. However, a highly smooth surface cannot be produced by grinding or cutting.

In known methods for producing a highly smooth surface, a sapphire substrate is polished using a polishing composition containing a relatively high concentration of colloidal silica (for example, refer to Japanese Laid-Open Patent Publication No. 2008-44078), and a silicon carbide substrate is polished using a polishing composition containing colloidal silica with a specific pH (for example, refer to Japanese Laid-Open Patent Publication No. 2005-117027). JP 2008 068390 A relates to a crystal material polishing method capable of obtaining sufficient polishing efficiency for a substrate such as silicon carbide SiC and gallium nitride GaN. WO 2009/046311 A2 comprises improved slurry compositions comprising silicon carbide particles and alumina particles dispersed within an aqueous medium. Slurry compositions are used for chemical mechanical planarization processes. EP 1 863 074 A2 describes a surface treatment method for nitride crystal used for a substrate, e.g. of a semiconductor device. In particular, this document discloses a surface treatment method of chemically and mechanically polishing a surface of a nitride crystal using abrasive grains of an oxide.

However, a problem associated with these methods is that much time is required for producing highly smooth surfaces, since a sufficient polishing rate (removal rate) is not provided.

### SUMMARY OF THE INVENTION

Accordingly, an objective of the present invention is to provide a method of polishing an object formed of sapphire or indium arsenide using a polishing composition and the use of a polishing composition for polishing an object formed of sapphire or indium arsenide.

To achieve the foregoing objectives, and in accordance with a first aspect of the present invention,
a method of polishing an object formed of a substrate material for optical devices, a substrate material for power devices, or a compound semiconductor material, is provided, wherein the method is characterized by:
JP 2008 068390 A relates to a crystal material polishing method capable of obtaining sufficient polishing efficiency for a substrate such as silicon carbide SiC and gallium nitride GaN.
WO 03/050859 A1 describes a chemical mechanical planarizing method for removing silicon carbide hardmask capping materials in the presence of Low-k dielectrics contained on semiconductor wafers.
WO 2009/046311 A2 comprises improved slurry compositions comprising silicon carbide particles and alumina particles dispersed within an aqueous medium. Slurry compositions are used for chemical mechanical planarization processes.
1 863 074 A2 describes a surface treatment method for nitride crystal used for a substrate, e.g. of a semiconductor device. In particular, this document discloses a surface treatment method of chemically and mechanically polishing a surface of a nitride crystal using abrasive grains of an oxide.
US 2002/185054 A1 is relates to a high quality wafer comprising Alₓ,Ga_{y},In_{z}N which is polished, using a CMP slurry comprising abrasive particles and an acid or a base.
preparing a polishing composition comprising at least abrasive grains selected from the group consisting of aluminum oxide, silicon oxide, zirconium oxide, diamond, and silicon carbide, a pH adjuster, and water, and
using the polishing composition to polish the object selected from the group consisting of sapphire or indium arsenide, wherein the preparing a polishing composition includes adjusting the pH of the polishing composition so as to satisfy the relationship X × Y ≤ 0 under the conditions during polishing of the object by using the polishing composition, where X [mV] represents the zeta potential of the abrasive grains and Y [mV] represents the zeta potential of the object. The expression X × Y has a value preferably not lower than -5,000.

A second aspect of the invention refers to the use of a polishing composition for polishing an object formed of a substrate material for optical devices, a substrate material for power devices, or a compound semiconductor material, wherein the object is selected from the group consisting of sapphire or indium arsenide, wherein the polishing composition contains at least abrasive grains selected from the group consisting of aluminum oxide, silicon oxide, zirconium oxide, diamond, and silicon carbide, a pH adjuster, and water,
wherein the pH of the polishing composition is adjusted so as to satisfy the relationship X × Y ≤ 0 under the conditions during polishing of the object by using the polishing composition, where X [mV] represents the zeta potential of the abrasive grains and Y [mV] represents the zeta potential of the object.

The polishing composition according to the first or the second aspect may further contain a substance that adsorbs to the object to be polished. The abrasive grains contained in the polishing composition according to the first or the second aspect may be surface-reformed.

Other aspects and advantages of the invention will become apparent from the following description illustrating by way of example the principles of the invention.

### DETAILED DESCRIPTION OF THE PREFERRED EMBODIMENTS

One embodiment of the present invention will now be described below.

A polishing composition of the present embodiment contains at least abrasive grains selected from the group consisting of aluminum oxide, silicon oxide, zirconium oxide, diamond, and silicon carbide, a pH adjuster, and water. The polishing composition is used in polishing an object to be polished formed of a substrate material for optical devices, a substrate material for power devices, or a compound semiconductor material, more specifically in polishing a substrate or a film formed of sapphire or compound semiconductor material indium arsenide. The polishing composition is preferably used in polishing an object to be polished formed of a material that remains stable with respect to chemical action such as oxidation, complexation, and etching, in particular in polishing a substrate formed of sapphire or indium arsenide.

The abrasive grains contained in the polishing composition are selected from the group consisting of aluminum oxide, silicon oxide, zirconium oxide, diamond, or silicon carbide. Aluminum oxide and silicon oxide have an advantage in easy availability for readily producing a highly smooth surface having few defects by polishing using the polishing composition.

The polishing composition contains preferably not less than 0.01% by mass, more preferably not less than 0.1% by mass of the abrasive grains. The more the amount of abrasive grains contained, the more enhanced becomes the rate of polishing an object to be polished using the polishing composition.

The polishing composition contains preferably not more than 50% by mass, more preferably not more than 40% by mass of the abrasive grains. The less the amount of abrasive grains contained, the more reduced becomes the cost of manufacturing the polishing composition. In addition, a polished surface having few scratches can be more readily produced by polishing using the polishing composition.

The polishing composition contains abrasive grains having a mean primary particle diameter of preferably not smaller than 5 nm, more preferably not smaller than 10 nm. The larger the mean primary particle diameter of the abrasive grains, the more enhanced becomes the rate of polishing an object to be polished using the polishing composition.

The polishing composition contains abrasive grains having a mean primary particle diameter of preferably not larger than 20 µm, more preferably not larger than 10 µm. The smaller the mean primary particle diameter of the abrasive grains, the more readily the surface having fewer defects and a small degree of roughness can be produced by polishing using the polishing composition. The mean primary particle diameter is calculated, for example, from the specific surface of the abrasive grains measured by the BET method. The specific surface of the abrasive grains is measured, for example, with a "Flow SorbII 2300" made by Micromeritics Instrument Corporation.

In order to polish an object formed of a substrate material for optical devices, a substrate material for power devices, or a compound semiconductor material at an enhanced rate of polishing using the polishing composition, it is important that the abrasive grains contained in the polishing composition are not electrostatically repelled from the object to be polished during polishing. For this reason, the abrasive grains for use have a zeta potential satisfying the relationship X × Y ≤ 0, where X [mV] represents the zeta potential of the abrasive grains measured in the polishing composition and Y [mV] represents the zeta potential of the object to be polished measured during polishing using the polishing composition. When the relationship X × Y ≤ 0 is not satisfied, that is, when the relationship X × Y > 0 is satisfied, the abrasive grains contained in the polishing composition are electrostatically repelled from the object to be polished during polishing, which creates difficulty in mechanically polishing the object to be polished with the abrasive grains. As a result, it is difficult to polish the object to be polished at an enhanced rate of polishing using the polishing composition. The expression X × Y has a value preferably not higher than -20 for enhancing the rate of polishing an object to be polished to a level particularly suitable for practical use with the polishing composition.

The expression X × Y has a value of preferably not lower than -5,000, and more preferably not lower than -2,000. The higher the value of the expression X × Y, the more readily the abrasive grains attaching to the polished surface of the object to be polished can be removed by washing.

The zeta potential value of the abrasive grains measured in the polishing composition and the zeta potential value of the object to be polished measured during polishing using the polishing composition are affected, for example, by the pH of the polishing composition. Accordingly, the relationship X×Y ≤ 0, preferably the relationship X × Y ≤ -20 may be satisfied with addition of one or more pH adjusters to the polishing composition. The pH adjuster for use may be either acid or alkali.

Alternatively, with addition of an adsorptive substance to the polishing composition, the zeta potential value of the object to be polished is varied with the substance adsorbed to the surface of the object to be polished. Accordingly, the relationship X × Y ≤ 0, preferably the relationship X × Y ≤ -20 may be satisfied with addition of such an adsorptive substance to the polishing composition. The adsorptive substance for use is preferably appropriately selected depending on the types of objects to be polished, and may be, for example, an anionic, cationic, nonionic, or zwitterionic surfactant, an organic matter, or metal ions.

Alternatively, in order to satisfy the relationship X × Y ≤ 0, preferably the relationship X × Y ≤ -20, the zeta potential of the abrasive grains may be adjusted by reforming the surface of the abrasive grains with doping or organic functional group modification.

The zeta potential values of the abrasive grains and the object to be polished are measured by an electrophoretic light scattering method or electroacoustic spectroscopy using, for example, an "ELS-Z" made by Otsuka Electronics Co., Ltd. or a "DT-1200" made by Dispersion Technology Inc. Measurement of the zeta potential of the object to be polished may be replaced with measurement of the zeta potential of fine particles composed of the same material as the object to be polished. Alternatively, the object to be polished is immersed in a liquid containing fine particles having a known zeta potential value, taken out from the liquid, and washed with running water for about 10 seconds, and then the surface of the object to be polished may be observed with, for example, a scanning electron microscope. In this case, whether a sign of the zeta potential value of the object to be polished measured in the liquid is positive or negative can be known from the amount of the fine particles attaching to the surface of the object to be polished after washing.

The present embodiment provides the following advantages.

In the polishing composition of the present embodiment, the abrasive grains for use have a zeta potential satisfying the relationship X × Y ≤ 0, where X [mV] represents the zeta potential of the abrasive grains measured in the polishing composition and Y [mV] represents the zeta potential of the object to be polished measured during polishing using the polishing composition. Accordingly, the abrasive grains contained in the polishing composition have such a zeta potential value as not to be electrostatically repelled from the object to be polished during polishing using the polishing composition. Since the abrasive grains contained in the polishing composition are not electrostatically repelled from the object to be polished during polishing, mechanical polishing of the object to be polished is efficiently performed with the abrasive grains. As a result, an object to be polished formed of a substrate material for optical devices, a substrate material for power devices, or a compound semiconductor material can be polished at an enhanced rate of polishing using the polishing composition.

The embodiment may be modified as described below.

The polishing composition of the embodiment may contain two or more kinds of abrasive grains. In this case, part of the abrasive grains need not have such zeta potential values as not to be electrostatically repelled from the object to be polished during polishing. However, in order to achieve a more enhanced rate of polishing, the abrasive grains preferably have such zeta potential values as not to be electrostatically repelled from the object to be polished during polishing.

The polishing composition of the embodiment may further contain a known additive such as an antiseptic as needed.

The polishing composition of the embodiment may be prepared by diluting a concentrate of the polishing composition with water.

Examples and Comparative Examples of the present invention will now be described below.

### [Examples 1 and 2 and Comparative Example 1]

Polishing compositions of Examples 1 and 2 and Comparative Example 1 were prepared by diluting a colloidal silica sol containing colloidal silica having a mean primary particle diameter of 80 nm with water and adding a pH adjuster as needed. Each of the polishing compositions of Examples 1 and 2 and Comparative Example 1 contained 20% by mass of colloidal silica. Hydrochloric acid or potassium hydroxide was appropriately used as a pH adjuster. Using each of the polishing compositions of Examples 1 and 2 and Comparative Example 1, a surface (c-plane (<0001 >)) of a sapphire substrate was polished under the conditions shown in Table 1. All the sapphire substrates used were of the same kind having a diameter of 52 mm (about 2 inches).

The pHs of the polishing compositions, zeta potential values of the colloidal silica measured in the polishing compositions, and zeta potential values of the sapphire substrates measured during polishing using the polishing compositions are shown in Table 2. The weights of the sapphire substrates were measured before and after polishing using the polishing compositions for calculation of the rates of polishing from the difference in weights before and after polishing. The calculated rates of polishing are shown in the column "polishing rate" of Table 2.

**Table 1**

| |
|---|
| <Sapphire substrate polishing conditions> |
| Polishing machine: Single side polisher "EJ-380IN" (surface plate diameter of 380 mm) |
| made by Engis Japan Corporation |
| Polishing pad: Nonwoven fabric polishing pad "SUBA800" made by Nitta Haas |
| Incorporated |
| Polishing pressure: 300 g/cm² (29.4 kPa) |
| Surface plate rotational rate: 110 rpm |
| Linear velocity: 83 m/min |
| Polishing time: 5 min |
| Polishing composition feed rate: 200 mL/min (continuously fed without being circulated) |

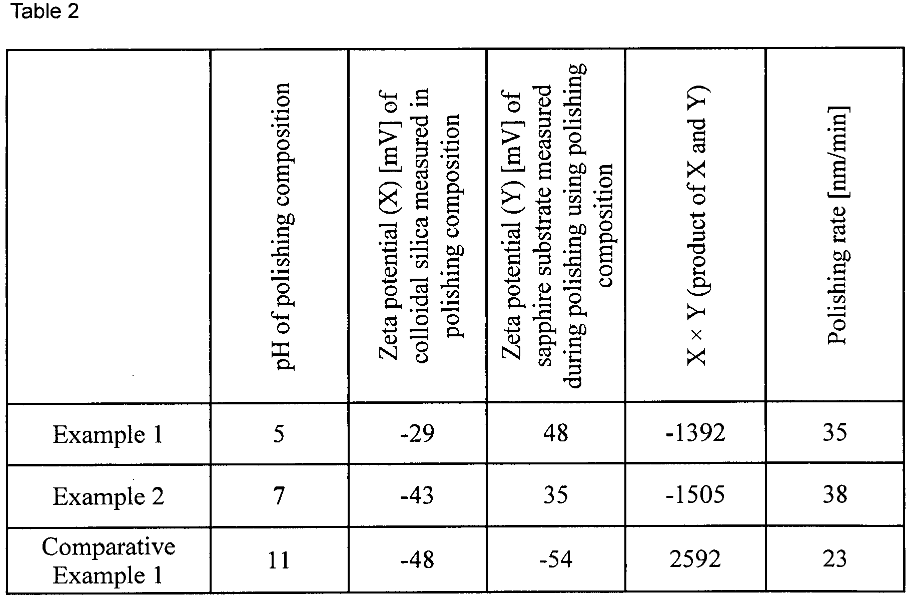

As shown in Table 2, when a sapphire substrate was polished using the polishing composition of Example 1 or 2, the product of the zeta potential of colloidal silica and the zeta potential of the sapphire substrate had a value not higher than zero. In contrast, when a sapphire substrate was polished using the polishing composition of Comparative Example 1, the product had a value higher than zero. Consequently, a higher polishing rate was achieved using the polishing composition of Example 1 or 2 compared to using the polishing composition of Comparative Example 1.

### [Reference Example 3 and Comparative Example 2]

Polishing compositions of Reference Example 3 and Comparative Example 2 were prepared by diluting a colloidal silica sol containing colloidal silica having a mean primary particle diameter of 80 nm with water and adding a pH adjuster as needed. Each of the polishing compositions of Reference Example 3 and Comparative Example 2 contained 20% by mass of colloidal silica. Hydrochloric acid or potassium hydroxide was appropriately used as a pH adjuster. Using each of the polishing compositions of Reference Example 3 and Comparative Example 2, a surface (Ga plane) of a gallium nitride substrate was polished under the conditions shown in Table 3. All the gallium nitride substrates used were of the same kind having 10 mm square.

The pHs of the polishing compositions, the sign of the zeta potential of the colloidal silica measured in each of the polishing compositions, and the sign of the zeta potential of the gallium nitride substrates measured during polishing using each of the polishing compositions are shown in Table 4. The weights of the gallium nitride substrates were measured before and after polishing using the polishing compositions for calculation of the rates of polishing from the difference in weights before and after polishing. The calculated rates of polishing are shown in the column "polishing rate" of Table 4.

**Table 3**

| |
|---|
| <Gallium nitride substrate polishing conditions> |
| Polishing machine: Single side polisher "EJ-380IN" (surface plate diameter of 380 |
| mm) made by Engis Japan Corporation |
| Polishing pad: Nonwoven fabric polishing pad "SURFIN SSW-1" made by Nitta |
| Haas Incorporated |
| Polishing pressure: 880 g/cm² (86.3 kPa) |
| Surface plate rotational rate: 100 rpm |
| Linear velocity: 75 m/min |
| Polishing time: 60 min |
| Polishing composition feed rate: 100 mL/min (continuously fed without being |
| circulated) |

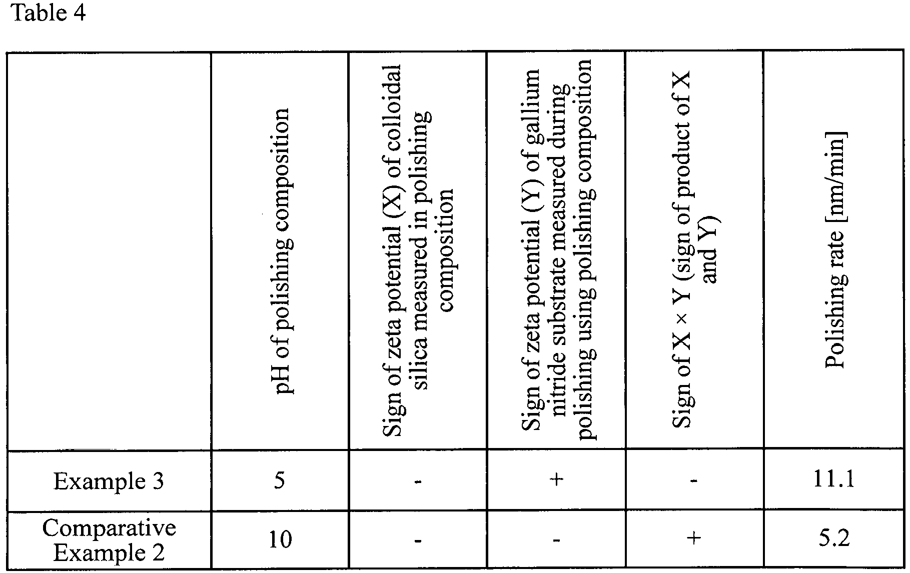

As shown in Table 4, when a gallium nitride substrate was polished using the polishing composition of Reference Example 3, the product of the zeta potential of colloidal silica and the zeta potential of the gallium nitride substrate had a negative sign. In contrast, when a gallium nitride substrate was polished using the polishing composition of Comparative Example 2, the product had a positive sign. Consequently, a higher polishing rate was achieved using the polishing composition of Reference Example 3 compared to using the polishing composition of Comparative Example 2.

### [Examples 4 and 5 and Comparative Examples 3 and 4]

Polishing compositions of Examples 4 and 5 and Comparative Examples 3 and 4 were prepared by diluting a colloidal silica sol containing colloidal silica having a mean primary particle diameter of 35 nm with water and adding a pH adjuster as needed. Each of the polishing compositions of Examples 4 and 5 and Comparative Examples 3 and 4 contained 5% by mass of colloidal silica. Acetic acid or potassium hydroxide was appropriately used as a pH adjuster. Using each of the polishing compositions of Examples 4 and 5 and Comparative Examples 3 and 4, a surface ((100) plane) of an indium arsenide substrate was polished under the conditions shown in Table 5. All the indium arsenide substrates used were of the same kind having a diameter of 52 mm (about 2 inches).

The pHs of the polishing compositions, the sign of the zeta potential of the colloidal silica measured in each of the polishing compositions, and the sign of the zeta potential of the indium arsenide substrates measured during polishing using each of the polishing compositions are shown in Table 6. The weights of the indium arsenide substrates were measured before and after polishing using the polishing compositions for calculation of the rates of polishing from the difference in weights before and after polishing. The calculated rates of polishing are shown in the column "polishing rate" of Table 6.

**Table 5**

| |
|---|
| <Indium arsenide substrate polishing conditions> |
| Polishing machine: Single side polisher "EJ-380IN" (surface plate diameter of 380 |
| mm) made by Engis Japan Corporation |
| Polishing pad: Nonwoven fabric polishing pad "POLITEX" made by Nitta Haas |
| Incorporated |
| Polishing pressure: 180 g/cm² (17.6 kPa) |
| Surface plate rotational rate: 50 rpm |
| Linear velocity: 37.5 m/min |
| Polishing time: 3 min |
| Polishing composition feed rate: 100 mL/min (continuously fed without being |
| circulated) |

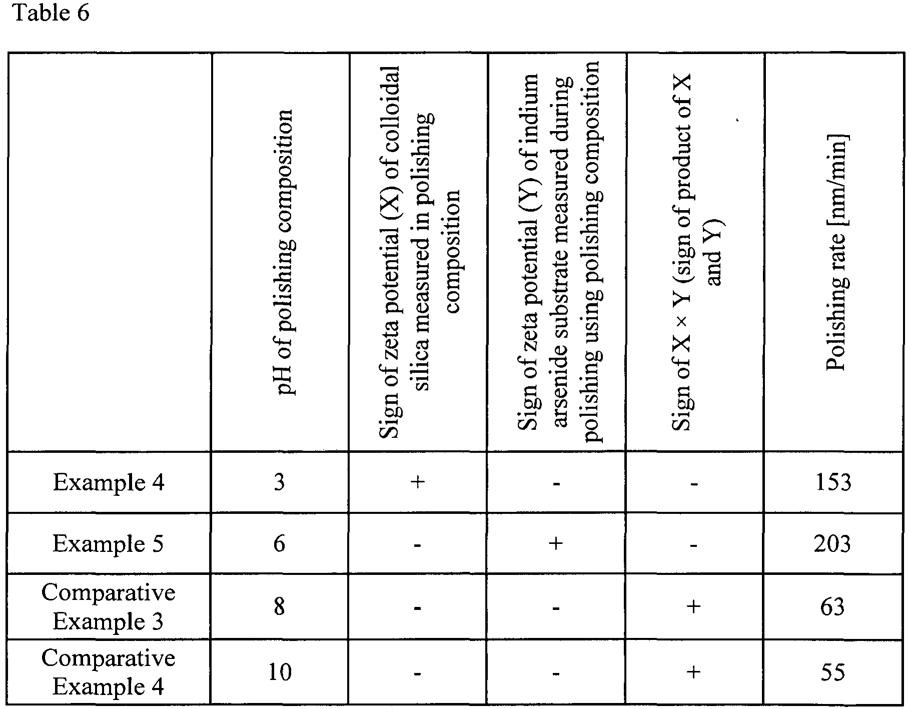

As shown in Table 6, when an indium arsenide substrate was polished using the polishing composition of Example 4 or 5, the product of the zeta potential of colloidal silica and the zeta potential of the indium arsenide substrate had a negative sign. In contrast, when an indium arsenide substrate was polished using the polishing composition of Comparative Example 3 or 4, the product had a positive sign. Consequently, a higher polishing rate was achieved using the polishing composition of Example 4 or 5 compared to using the polishing composition of Comparative Example 3 or 4.

## Claims

1. A method of polishing an object formed of a substrate material for optical devices, a substrate material for power devices, or a compound semiconductor material, the method **characterized by**:
preparing a polishing composition comprising at least abrasive grains selected from the group consisting of aluminum oxide, silicon oxide, zirconium oxide, diamond, and silicon carbide, a pH adjuster, and water, and
using the polishing composition to polish the object selected from the group consisting of sapphire or indium arsenide, wherein the preparing a polishing composition includes adjusting the pH of the polishing composition so as to satisfy the relationship X × Y ≤ 0 under the conditions during polishing of the object by using the polishing composition, where X [mV] represents the zeta potential of the abrasive grains and Y [mV] represents the zeta potential of the object.

2. The method according to claim 1, wherein the adjusting the pH of the polishing composition includes measuring the zeta potential of fine particles composed of the same material as the object instead of measuring the zeta potential of the object.

3. The method according to claim 1 or 2, wherein the pH of the polishing composition is adjusted so as to satisfy the relationship X × Y ≤ -20.

4. The method according to claim 1 or 2, wherein the pH of the polishing composition is adjusted so as to satisfy the relationship -5,000 < X × Y ≤ 0.

5. The method according to any one of claims 1 to 4, wherein the polishing composition further contains a substance that adsorbs to the object to be polished.

6. The method according to any one of claims 1 to 5, wherein the abrasive grains are surface-reformed.

7. The method according to any one of claims 1 to 6, wherein the object is sapphire.

8. The method according to any one of claims 1 to 6, wherein the object is indium arsenide.

9. Use of a polishing composition for polishing an object formed of a substrate material for optical devices, a substrate material for power devices, or a compound semiconductor material, wherein the object is selected from the group consisting of sapphire or indium arsenide, wherein the polishing composition contains at least abrasive grains selected from the group consisting of aluminum oxide, silicon oxide, zirconium oxide, diamond, and silicon carbide, a pH adjuster, and water,
wherein the pH of the polishing composition is adjusted so as to satisfy the relationship X × Y ≤ 0 under the conditions during polishing of the object by using the polishing composition, where X [mV] represents the zeta potential of the abrasive grains and Y [mV] represents the zeta potential of the object.

## Patentansprüche

1. Verfahren zum Polieren eines Gegenstandes gebildet aus einem Substratmaterial für optische Vorrichtungen, einem Substratmaterial für Netzteile oder einem Verbindungshalbleitermaterial, wobei das Verfahren charakterisiert ist durch:
Herstellen einer Polierzusammensetzung umfassend mindestens Schleifkörner ausgewählt aus der Gruppe bestehend aus Aluminiumoxid, Siliciumoxid, Zirkoniumoxid, Diamant und Siliciumkarbid, einem pH-Regulierer und Wasser, und
Verwenden der Polierzusammensetzung, um einen Gegenstand ausgewählt aus der Gruppe bestehend aus Saphir oder Indiumarsenid zu polieren, wobei die Herstellung einer Polierzusammensetzung das Regulieren des pH der Polierzusammensetzung umfasst, so dass diese das Verhältnis X x Y ≤0 unter den Bedingungen während des Polierens des Gegenstandes mit der Polierzusammensetzung erfüllt, wobei X [mV] das Zeta-Potential der Schleifkörnern und Y [mV] das Zeta-Potential des Gegenstandes repräsentiert.

2. Verfahren gemäß Anspruch 1, wobei das Regulieren des pH der Polierzusammensetzung das Messen des Zeta-Potentials der feinen Partikel zusammengesetzt aus demselben Material wie der Gegenstand anstatt des Messens des Zeta-Potentials des Gegenstandes beinhaltet.

3. Verfahren gemäß einem der Ansprüche 1 oder 2, wobei der pH der Polierzusammensetzung so angepasst ist, dass er das Verhältnis X x Y ≤ -20 erfüllt.

4. Verfahren gemäß der Ansprüche 1 oder 2, wobei der pH der Polierzusammensetzung angepasst ist, so dass er das Verhältnis -5.000 ≤X x Y ≤ 0 erfüllt.

5. Verfahren gemäß einem der Ansprüche 1 bis 4, wobei die Polierzusammensetzung ferner eine Substanz, die an den zu polierenden Gegenstand adsorbiert, enthält.

6. Verfahren gemäß einem der Ansprüche 1 bis 5, wobei die Schleifkörner oberflächenverbessert sind.

7. Verfahren gemäß einem der Ansprüche 1 bis 6, wobei der Gegenstand Saphir ist.

8. Verfahren gemäß einem der Ansprüche 1 bis 6, wobei der Gegenstand Indiumarsenid ist.

9. Verwendung einer Polierzusammensetzung zum Polieren eines Gegenstandes gebildet aus einem Substratmaterial für optische Vorrichtungen, einem Substratmaterial für Netzteile oder einem Verbindungshalbleitermaterial, wobei der Gegenstand ausgewählt ist aus der Gruppe bestehend aus Saphir oder Indiumarsenid, wobei die Polierzusammensetzung mindestens Schleifkörner ausgewählt aus der Gruppe bestehend aus Aluminiumoxid, Siliciumoxid, Zirkoniumoxid, Diamant und Siliciumkarbid, einen pH-Regulierer und Wasser enthält,
wobei der pH der Polierzusammensetzung so angepasst ist, dass er das Verhältnis X x Y ≤0 unter den Bedingungen während des Polierens des Gegenstandes durch Verwendung der Polierzusammensetzung erfüllt, wobei X [mV] das Zeta-Potential der Schleifkörner und Y [mV] das Zeta-Potential des Gegenstandes repräsentiert.

## Revendications

1. Procédé de polissage d'un objet constitué d'un matériau de substrat pour appareils optiques, d'un matériau de substrat pour appareils de puissance, ou d'un matériau semiconducteur composite, le procédé étant **caractérisé par** :
la préparation d'une composition de polissage comprenant au moins des grains abrasifs sélectionnés dans le groupe constitué par l'oxyde d'aluminium, l'oxyde de silicium, l'oxyde de zirconium, le diamant, et du carbure de silicium, un ajusteur de pH, et de l'eau, et
l'utilisation de la composition de polissage pour polir l'objet sélectionné dans le groupe constitué par le saphir ou l'arséniure d'indium, sachant que la préparation d'une composition de polissage inclut l'ajustement du pH de la composition de polissage de manière à satisfaire à la relation X x Y ≤ 0 dans les conditions pendant le polissage de l'objet au moyen de la composition de polissage, où X [mV] représente le potentiel zêta des grains abrasifs et Y [mV] représente le potentiel zêta de l'objet.

2. Le procédé selon la revendication 1, sachant que l'ajustement du pH de la composition de polissage inclut la mesure du potentiel zêta de particules fines composées du même matériau que l'objet à la place de la mesure du potentiel zêta de l'objet.

3. Le procédé selon la revendication 1 ou 2, sachant que le pH de la composition de polissage est ajusté de manière à satisfaire à la relation X x Y ≤ -20.

4. Le procédé selon la revendication 1 ou 2, sachant que le pH de la composition de polissage est ajusté de manière à satisfaire à la relation -5 000 ≤ X x Y ≤ 0.

5. Le procédé selon l'une quelconque des revendications 1 à 4, sachant que la composition de polissage contient en outre une substance qui s'adsorbe à l'objet à polir.

6. Le procédé selon l'une quelconque des revendications 1 à 5, sachant que les grains abrasifs ont subi une reformation de surface.

7. Le procédé selon l'une quelconque des revendications 1 à 6, sachant que l'objet est du saphir.

8. Le procédé selon l'une quelconque des revendications 1 à 6, sachant que l'objet est de l'arséniure d'indium.

9. Utilisation d'une composition de polissage pour le polissage d'un objet constitué d'un matériau de substrat pour appareils optiques, d'un matériau de substrat pour appareils de puissance, ou d'un matériau semiconducteur composite, sachant que l'objet est sélectionné dans le groupe constitué par le saphir ou l'arséniure d'indium, sachant que la composition de polissage contient au moins des grains abrasifs sélectionnés dans le groupe constitué par l'oxyde d'aluminium, l'oxyde de silicium, l'oxyde de zirconium, le diamant, et du carbure de silicium, un ajusteur de pH, et de l'eau,
sachant que le pH de la composition de polissage est ajusté de manière à satisfaire à la relation X x Y ≤ 0 dans les conditions pendant le polissage de l'objet au moyen de la composition de polissage, où X [mV] représente le potentiel zêta des grains abrasifs et Y [mV] représente le potentiel zêta de l'objet.
